# EUROPEAN PATENT SPECIFICATION

(11) **EP 4 364 195 B1**
(45) Date of publication and mention of the grant of the patent: **05.11.2025**
(21) Application number: 22732412.6
(22) Date of filing: 23.05.2022
(51) Int. Cl.: H01L 23/32, G06N 10/40

(54) **HOLDER AND MOUNTING METHOD FOR QUANTUM DEVICE**
VORRICHTUNG UND VERFAHREN ZUM HALTEN EINES QUANTENBAUTEILS
SUPPORT ET MÉTHODE DE MONTAGE D'UN DISPOSITIF QUANTIQUE

(30) Priority: 02.07.2021 EP 21183389
(43) Date of publication of application: 08.05.2024
(73) Proprietor: QM Technologies ApS, 2750 Ballerup (DK)
(72) Inventor: ANDRESEN, Søren, 2750 Ballerup (DK); KANN, Peter Ulrik, 2750 Ballerup (DK); VON SOOSTEN, Merlin, 2750 Ballerup (DK)
(74) Representative: Inspicos P/S
(86) International application number: PCT/EP2022/063858
(87) International publication number: WO 2023/274629

(56) References cited:
- US-A1- 2020 100 357
- US-B1- 11 152 707
- AVERKIN A S ET AL: "Broadband sample holder for microwave spectroscopy of superconducting qubits", REVIEW OF SCIENTIFIC INSTRUMENTS, vol. 85, 104702, 8 October 2014 (2014-10-08), XP012190912, DOI: 10.1063/1.4896830
- LIENHARD B ET AL: "Microwave Packaging for Superconducting Qubits", 2019 IEEE MTT-S INTERNATIONAL MICROWAVE SYMPOSIUM, 2-7 JUNE 2019, BOSTON, MA, 2 June 2019 (2019-06-02), pages 275 - 278, XP033579690, DOI: 10.1109/mwsym.2019.8701119

## Description

The present invention relates to a sample holder and more particularly a sample holder for a cryogenic quantum device, which sample holder is simple to mount the quantum device inside while providing the protection and cooling required by the quantum device.

A sample holder may be seen in e.g. "Microwave Packaging for Superconducting Qubits", Lienhard et al., 12 June 2019, MIT, (https://arxiv.org/abs/1906.05425) also presented in "Microwave Package Design for Superconducting Quantum Processors", Huang et al., 16 April 2021, MIT, PRX QUANTUM 2, 020306. Other relevant technology may be seen in US2020/100357 and "Broadband sample holder for microwave spectroscopy of superconducting qubits", by Averkin AS et al, Review of Scientific instruments, vol. 85, 104702, 8/10 2014.

In a first aspect, the present invention relates to an assembly of a quantum device and a sample holder, the sample holder comprising:
- a first portion comprising a first cavity,
- a second portion comprising a second cavity,
- first fixing elements comprising a printed circuit board configured to bias the quantum device toward the first portion, the printed circuit board comprising electrically conducting elements and/or wave guides, and
- one or more electrical conductor(s) and/or wave guide(s) and
- second fixing elements configured to fix the first and second portions to each other,
wherein:
- the quantum device covers at least part of the first cavity,
- the quantum device covers at least part of the second cavity,
- the quantum device is fixed to the first portion by the first fixing elements and
- the electrically conducting elements and/or wave guides are connected to the quantum device and extend to outside of the first and second portions.

In this context, an assembly comprises a number of individual elements which may or may not be fixed to each other. Each element of the assembly may itself be monolithic or a combination of a number of elements.

A quantum device may be any type of device, often a device for use under cryogenic conditions, which may be used in relation to e.g. quantum computers. A quantum device may comprise one or more qubits, either based on superconducting junction devices embedded in one or more microwave transmission lines, single electron charging devices coupled to microwave resonators and other device concepts relying on read-out of quantum information by coupling to a microwave transmission line.

The first portion may comprise a first surface in which the first cavity is provided or from which the first cavity extends. The second portion may comprise a second surface in which the second cavity is provided or from which the second cavity extends. When the first and second portions are fixed to each other, they may be positioned with the first surface and the second surface facing each other.

The first cavity may have an opening defining a first contour, and the second cavity may have an opening defining a second contour. When the first and second portions are fixed to each other, the first and second contours may overlap, such as when projected on to a predetermined plane, such as a plane extending between the first and second portions.

The second fixing elements may be any type of fixing elements, such as screws, bolts, clamps, glue, adhesive, welds, soldering, springs, resilient elements or the like. It may be desired that the second fixing elements also perform other tasks, such as thermal transport, so bolts/screws/clamps may be preferred.

The first fixing elements fix the quantum device in relation to the first portion. These fixing elements comprise a printed circuit board comprising the electrically conducting elements and/or wave guides. The fixing elements may have additional tasks as will be described below.

Electrical connection between the electrically conducting elements and/or wave guides of the printed circuit board and electrically conducting elements and/or waveguides of the quantum device may be obtained in a number of manners. In one situation, the electrical connections are provided using soldering or wire bonding between the elements/waveguides of the PCB and quantum device, such as after fixing the quantum device in relation to the PCB.

Alternatively, resilient elements may be provided between the elements/waveguides of the PCB and those of the quantum device. Resilient elements may be springs, deformable elements, such as of a soft or resilient material. When it is desired that the resilient elements are electrically conducting, such as when used for interconnecting e.g. an electrically conducting element of the PCB with one of the quantum device, it may be made of an electrically conducting elements. Springs may be made of most electrically conducting materials. Resilient elements may be made from e.g. foams of or comprising electrical conductors. Some materials may in themselves be sufficiently resilient to be used as solid portions, such as drops or pellets, capable of being deformed to perform the interconnection desired. Such soft or resilient electrical conducting materials may, for example, be:
- Soft metals as indium, lead or tin
- Compliant insulators such as polymers or silicones with metallic elements incorporated
- Compliant insulators such as polymers or silicones, doped (chemical) or filled (physical) to establish sufficient conductivity and/or
- Conductive synthetic polymers or silicones

When fixed in relation to the first portion, the quantum device covers at least part of the first cavity. The quantum device may be positioned or provided over the first cavity. In this context, the quantum device may have a predetermined outline, when projected to the above plane, inside which at least a portion of the outline of the first contour is provided. It may be desired that at least an active portion or circuit or elements of the quantum device are provided squarely within the first contour in that plane, as they will then be better able to interfere with, detect, receive, emit, output or the like electromagnetic radiation provided in the cavity. The situation is the same in relation to the second cavity.

In addition, when the first and second portions are fixed to each other, the quantum device is provided over and covering at least part of the second cavity. The same considerations are applicable in relation to the second cavity.

In this context, it may be desired that the device is fixed to the first portion at a surface of the portion defining a first plane. It may be desired that the first portion extends only on one side of that plane, so that the mounting or fixing of the device need not be performed in a deep cavity but at a surface where it may easily be mounted, fixed, connected to and the like.

Finally, the electrically conducting elements and/or wave guides are connected to the quantum device and extend to outside of the first and second portions. In this manner, electrical signals or electromagnetic waves, such as radiation, RF signals or microwaves, may be transported to/from the device and/or cavity/ies.

In one embodiment, the PCB is embodied as a flexible element configured to bias the quantum device toward the first portion. In this manner, the fixing may be provided using only friction. The biasing force may be tailored to the quantum device to ensure that the fixing is sufficient yet not exceeded also after a large temperature change.

The PCB may be a plane element configured to extend between the first and second portions. Thus, the PCB may comprise shielding elements configured to block electromagnetic waves or radiation from travelling inside the PCB from the cavities and to surroundings of the first and second portions. The PCB may have an outer contour, in the plane, inside of which part of or all of the first and/or second portion is provided.

The PCB may itself be biased toward the first portion or attached thereto, such as using screws/bolts, glue, adhesives or the like.

In one embodiment, the assembly further comprises a cut-out portion at the first cavity, such as surrounding the first cavity, the quantum device being provided in the cut-out portion. In this manner, the device may be at least partly fixed in its position by edges of the cut-out portion. The portion may have a contour matching or only slightly larger than that of the device. To allow the device to be received therein. It may be preferred that the cut-out portion has a first depth and the quantum device, such as outer portions thereof received in the cut-out portion, has a first height, where the first height exceeds the first depth. It may be desired that the first height is between 150% and 100% of the first depth, so that up to 33% of the device height, such as up to 20%, such as up to 10%, such as up to 5%, extends outside of the cut-out portion.

The portion of the device extending out of the cut-out portion may be engaged by the first fixing elements, such as in the form of the above flexible PCB for obtaining the biasing. The first fixing elements may be biased toward a surface of the first portion, such as at the first surface, having the cut-out portion and the cavity. Then, due to the portion of the device extending out of the cut-out portion, a biassing may be applied of the corresponding portions of the device in a direction into or toward the cut-out portions.

Another manner of obtaining the same effect would be if the PCB had a cut-out or by providing an element, such as a washer-type element, at the first cut-out, the element having a suitable hole and a thickness corresponding to the desired cut-out. Also, a cut-out could be made in outer parts of the quantum device. Naturally any combination of these solutions would work.

It may be desired that only outer portions of the device are engaged by the first fixing means in order to e.g. allow more central portions to be exposed to e.g. radiation in the cavity.

The wave guides and/or electrically conducting elements may be provided on a surface of and/or inside the printed circuit board. The circuit board may comprise a base material, such as a polymer, ceramic or composite, which is not electrically conducting on which or inside which one or more electrically conducting elements and/or wave guides are provided. Conducting elements or wave guides may be provided on a surface of a base material and covered by another material, such as to avoid emission of radiation, noise or waves and/or avoid short circuiting when contacting with other elements, such as electrically conducting elements.

The electrically conducting elements and/or wave guides preferably extend from the device, such as inside the cavity/cavities, and to outside of the first and second portions. Thus, outside equipment, such as wave or signal generators and/or wave or signal detectors may be coupled, via the electrically conducting elements and/or wave guides to the device, such as for operation, test or the like.

In one embodiment, the assembly further comprises an electromagnetic shielding surrounding a main portion of the first and second portions. A suitable shielding may be of a superconducting material. Openings may be made in the material to e.g. transfer electrical signals and/or waves to/from the electrically conducting elements and/or wave guides. Openings may also be provided for cooling the assembly and/or fixing or supporting the assembly.

It may be preferred that the assembly is cooled to a temperature below 100K, such as below 50K, such as below 10K, such as below 1K. This may be desired for or required for the device to operate as desired.

Another aspect of the invention relates to a method of mounting a quantum device in an assembly according to the first aspect of the invention, the method comprising:
a) fixing the quantum device to the first portion so as to cover at least a portion of the first cavity,
b) fixing the second portion to the first portion so that the quantum device covers at least a portion of the second cavity, and
c) electrically connecting the quantum device to the electrically conducting elements and/or wave guides which preferably extend to outside of the first and second portions to the quantum device.

Naturally, all embodiments, situations and considerations described above are equally valid for the present aspect of the invention.

Also, if electrical connection is desired to the device, this may be handled before step c).

Thus, step a) may be performed before step b), so that the quantum device may be fixed to the first portion without the second portion being in the way. Having fixed the quantum device to the first portion and potentially provided the electrical and/or wave connections, the second portion may be fixed to the first portion in order to assemble the assembly and enclose the device in the common cavity. The common cavity may be formed by inner surface of the first and second cavities but also additional elements, such as the above-mentioned cut-out portions, the first fixing elements and the like.

In one embodiment, step a) comprises biasing, via the PCB, which may be a flexible element, the quantum device toward the first portion. The PCB may then be fixed to, adhered to or biased toward the first portion and may then itself bias the quantum device toward the first portion to prevent the device from displacing vis-à-vis the first portion.

As described above, step c) comprises electrically connecting the quantum device to the electrically conducting elements and/or wave guides. As explained above, the conducting elements and/or wave guides extend to outside of first and second elements to allow easy connection thereto.

In one embodiment, the first portion comprises a cut-out portion at the first cavity, wherein step a) comprises providing the quantum device in the cut-out portion. Subsequently, the fixing or biassing may be performed to prevent the device from leaving the cut-out portion.

In one situation, the cut-out portions have a first depth and the quantum device, such as outer portions thereof, have a first height, where the first height exceeds the first depth. This is explained above.

It may be desired to provide an electromagnetic shielding, preferably of a superconducting material, surrounding at least a main portion of the first and second portions. Openings may be provided in the shield, such as for contacting the electrically conducting elements and/or wave guides as well as for engaging the assembly for fixing or cooling it.

As explained, it may be preferred to cool the assembly to a temperature below 100K.

In the following, preferred embodiments are described with reference to the drawing, wherein:
- Figure 1 illustrates a cross section through a preferred sample holder according to the invention,
- Figure 2 illustrates different cut-out types and
- Figure 3 illustrates different manners of connecting conducting elements.

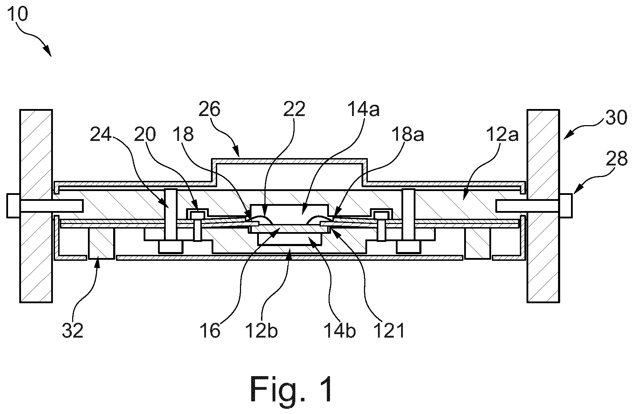

In figure 1, a sample holder 10 is illustrated generally comprising an upper portion 12a and a lower portion 12b. The lower portion 12b has a cavity 14b over which a quantum device 16 is provided. The device 16 is provided in a cut-out portion 121 which may delimit movement of the device in a direction in a plane of the device. The device 16 is biased downward by a PCB, 18 clamped to the lower element 12b by screws 20.

The PCB comprises conducting portions which may be connected to the device either by the direct connection between the device and PCB or via other manners such as wire bonds 22. Wire bonds 22 are especially useful when the connection portions are provided on surfaces facing at least generally in the same direction and which are exposed. When the connection portions are provided on surfaces facing each other, these may overlap, so that electrically conducting, resilient elements may be provided between the PCB and the quantum device and more particularly between pairs of a conductor or connection portion of the quantum device and one of the PCB. Such resilient elements may be springs or balls/drops, such as made from any conducting material, such as metals or any of the above-mentioned materials, which may be fixed to one of the PCB and the quantum device before assembly if desired.

The device may be biased toward the lower portion 12b by a biassing provided by the PCB 18. In this manner, the device may be fixed in a position without exerting a too large force on to it. The PCB may be selected or dimensioned to provide the biasing desired.

Also, the height or depth of the cut-out or indentation 121 may be selected only slightly lower than a height of the quantum device, such as outer portions of the quantum device 16, so that the PCB needs flex only slightly to provide the desired biasing.

Then, the device 16 is positioned in a combined cavity which may be used for e.g. providing microwaves to and/or receiving microwaves from the device, such as for affecting or reading-out one or more cubits on the device. The flexible element may comprise microwave antennas, microwave guides, RF antennas and/or RF conductors in order to provide such radiation to and/or remove such radiation from the device or cavity.

Thus, the electrical contacting to the device may be used for testing the device and/or operating the device. The testing may comprise feeding signals to the device and receiving signal therefrom for later analysis to derive information from or relating to the device.

The upper and lower portions are bolted to each other using bolts 24. In this manner, the upper and lower portions form a sealed space or cavity holding the device.

Electrical contacting from the outside of the assembly may be achieved via contacts or connectors 32 extending away from the PCB 18. Connectors 32 may be for electrical contacting, coaxial feeding and/or RF or microwave signals and may be achieved via connectors mounted to the PCB 18.

The PCB 18 may have on a surface thereof electrically conducting portions or traces. To prevent contact with the element 12a, another element, 18a, may be provided, which is not electrically conducting. As illustrated, the element 18a allows the PCB 18 to be exposed and contactable at the portion closest to the device 16. This contacting may be by wire bonding or direct physical contact, or contact via soldering, welding, electrically conducting glue or the like, between conductors of the PCB and of the device. It may be preferred that only the PCB 18 extends over the device so as to bias it. Alternatively, also the element 18a may be used for this purpose, such as if the PCB itself is not able to provide a sufficient biasing force.

The upper and lower portions as well as the bolts 24 may be selected to allow efficient cooling from outside of the assembly, such as a cryogenic interface 30, to the cavity and the device, as in a preferred embodiment, the device is a quantum device for operations at temperatures below 100K, such as below 10K, such as below 1K.

Especially in such situations, the assembly may further comprise a superconducting EMC shield 26 is placed all around the assembly to further shield out any microwave background from reaching into the cavity.

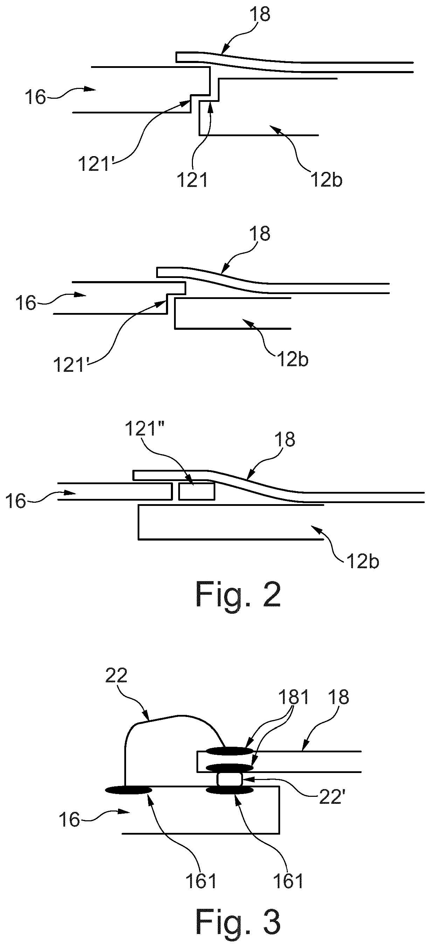

Figure 2 illustrates portions of the lower portion 12b, the device 16 and the PCB 18 in different embodiments where, in the upper illustration, both the device 16 and the lower portion 12b have cut-outs, 121' and 121, respectively. In the middle illustration, the device 16 has a cutout 121', and in the lower illustration, no cut-outs are provided. Instead, a washer 121" is provided which may be fixed to the lower portion 12b to thereby guide or control the device 16 in the same manner as the cut-outs.

In figure 3, different manners of electrically connecting the PCB 18 and the device 16 are provided. As described in relation to figure 1, wire bonds 22 may be used between electrically conducting elements or wave guides 181 of the PCB 18 and 161 of the device 16. This is the easiest if the surfaces on which the elements/guides 181 and 161 are exposed and face in the same direction. If the elements/guides are provided on surfaces facing each other, these elements/guides may be positioned opposite to each other, so that electrically conducting elements 22' may be positioned between the elements/guides 161/181 and thus provide the electrical contact. The electrical contact may be provided or increased if or when the PCB is biased toward the element 16.

Optimal performance of the design may be ensured by careful selection of materials and surface treatments:
1. The PCB 18 is constructed from low-loss dielectric material, e.g. PTFE or composites based thereon, with signal and ground layers made of either highly conductive copper and/or superconductive layers. The metal layers may be surface plated by either gold or superconductive metals to improve the electrical performance and avoid oxidation.
2. The upper and lower portions 12a/12b are made out of highly conductive metal, e.g. copper and/or alloys thereof. Surface plating by gold or other passivation is used to avoid oxidation and improve thermal contact. Superconducting surface plating of the cavity inner surfaces may be used to improve the electrical performance.
3. The bolts 24 that fix the portions to each other as well as any bolts 28 for mounting the assembly onto the cryogenic interface 30 are made from beryllium copper, ensuring efficient thermalization and also providing better mechanical strength than pure copper metal.
4. The superconducting EMC shields 26 on the outside of the package can be made from different superconducting materials, e.g. aluminium, niobium, titanium and/or alloys thereof. To ensure fully connected EMC shielding, the parts may be surface treated to avoid insulating oxides, e.g. by chrome passivation, zincate treatment or similar.

All ingoing parts are made from carefully selected non-magnetic metals and alloys to avoid stray magnetic fields that may disturb the performance of superconducting quantum devices. Furthermore, the whole package may be positioned in an external magnetic shielding consisting of both a superconducting can and a mu-metal enclosure. The superconductor will repel all magnetic fields by its inherent Meissner effect, whereas the mu-metal enclosure helps to avoid trapping of magnetic flux in the superconductor during cool-down.

All parts are designed with vent ports from all inner cavities 14a/14b to allow trapped air to escape to vacuum before cool-down. At the same time, no line-of-sight is allowed from the outside through both the superconducting EMC shielding and the frame parts that form the cavity. That would allow microwave background radiation to leak into the cavity. Therefore, also fully EMC tight superconducting flanges are used to seal off the connector fittings and the exposed ports around the screws for mounting onto the cryogenic interface.

## Claims

1. An assembly of a quantum device (16) and a sample holder (10), the sample holder comprising:
- a first portion (12b) comprising a first cavity (14b),
- a second portion (12a) comprising a second cavity (14a),
- first fixing elements comprising a printed circuit board (18) configured to bias the quantum device toward the first portion, the printed circuit board comprising electrically conducting elements and/or wave guides, and
- second fixing elements (24) configured to fix the first and second portions to each other,
wherein:
- the quantum device covers at least part of the first cavity,
- the quantum device covers at least part of the second cavity,
- the quantum device is fixed to the first portion by the first fixing elements, and
- the electrically conducting elements and/or wave guides are connected to the quantum device and extend to outside of the first and second portions.

2. An assembly according to claim 1, further comprising a cut-out portion (121) at the first cavity (14b), the quantum device (16) being provided in the cut-out portion.

3. An assembly according to claim 2, wherein the cut-out portion has a first depth and the quantum device has a first height, where the first height exceeds the first depth.

4. An assembly according to any of the preceding claims, further comprising an electromagnetic shielding (26) surrounding a main portion of the first and second portions.

5. An assembly according to any of the preceding claims, cooled to a temperature below 100K.

6. A method of mounting a quantum device in an assembly according to any of the preceding claims, the method comprising:
a) fixing the quantum device (16) to the first portion (12b) so as to cover at least a portion of the first cavity (14b),
b) fixing the second portion to the first portion so that the quantum device covers at least a portion of the second cavity (14a), and
c) electrically connecting the quantum device to the electrically conducting elements and/or wave guides.

7. A method according to claim 6, wherein step a) comprises biasing, via the printed circuit board (18), the quantum device toward the first portion.

8. A method according to any of claims 6-7, wherein the first portion comprises a cut-out portion (121) at the first cavity, wherein step a) comprises providing the quantum device in the cut-out portion.

9. A method according to claim 8, wherein the cut-out portion has a first depth and the quantum device has a first height, where the first height exceeds the first depth.

10. A method according to any of claims 6-9, further comprising a step of providing an electromagnetic shielding (26) surrounding a main portion of the first and second portions.

11. A method according to any of claims 6-10, further comprising a step of cooling the assembly to a temperature below 100K.

## Claims (Claims for the following Contracting State(s): DE, GB)

1. An assembly of a quantum device (16) and a sample holder (10), the sample holder comprising:
- a first portion (12b) comprising a first cavity (14b),
- a second portion (12a) comprising a second cavity (14a),
- first fixing elements comprising a printed circuit board (18) configured to bias the quantum device toward the first portion, the printed circuit board comprising first electrically conducting elements (181), and
- second fixing elements (24) configured to fix the first and second portions to each other,
wherein:
- the quantum device covers at least part of the first cavity,
- the quantum device covers at least part of the second cavity,
- the quantum device is fixed to the first portion by the first fixing elements, and
- the first electrically conducting elements are electrically connected to second electrically conducting elements (161) of the quantum device and extend to outside of the first and second portions
- the first electrically conducting elements face the second electrically conducting elements.

2. An assembly according to claim 1, further comprising a cut-out portion (121) at the first cavity (14b), the quantum device being provided in the cut-out portion.

3. An assembly according to claim 2, wherein the cut-out portion has a first depth and the quantum device has a first height, where the first height exceeds the first depth.

4. An assembly according to any of the preceding claims, further comprising an electromagnetic shielding (26) surrounding a main portion of the first and second portions.

5. An assembly according to any of the preceding claims, cooled to a temperature below 100K.

6. An assembly according to claim 1, further comprising third electrically conducting elements (22') between the first and second electrically conducting elements.

7. A method of mounting a quantum device in an assembly according to any of the preceding claims, the method comprising:
a) fixing the quantum device (16) to the first portion (12b) so as to cover at least a portion of the first cavity (14b),
b) fixing the second portion (12a) to the first portion so that the quantum device covers at least a portion of the second cavity (14a), and
c) electrically connecting the quantum device to the electrically conducting elements.

8. A method according to claim 7, wherein step a) comprises biasing, via the printed circuit board (18), the quantum device toward the first portion.

9. A method according to any of claims 7-8, wherein the first portion comprises a cut-out portion (121) at the first cavity, wherein step a) comprises providing the quantum device in the cut-out portion.

10. A method according to claim 9, wherein the cut-out portion has a first depth and the quantum device has a first height, where the first height exceeds the first depth.

11. A method according to any of claims 7-10, further comprising a step of providing an electromagnetic shielding (26) surrounding a main portion of the first and second portions.

12. A method according to any of claims 7-11, further comprising a step of cooling the assembly to a temperature below 100K.

## Patentansprüche

1. Baugruppe aus einer Quantenvorrichtung (16) und einem Probenhalter (10), wobei der Probenhalter Folgendes umfasst:
- einen ersten Abschnitt (12b) umfassend eine erste Kavität (14b),
- einen zweiten Abschnitt (12a) umfassend eine zweite Kavität (14a),
- erste Befestigungselemente umfassend eine Leiterplatte (18), die konfiguriert ist, um die Quantenvorrichtung in Richtung des ersten Abschnitts vorzuspannen, wobei die Leiterplatte elektrisch leitfähige Elemente und/oder Wellenleiter umfasst, und
- zweite Befestigungselemente (24), die konfiguriert sind, um den ersten und den zweiten Abschnitt aneinander zu befestigen,
wobei:
- die Quantenvorrichtung mindestens einen Teil der ersten Kavität bedeckt,
- die Quantenvorrichtung mindestens einen Teil der zweiten Kavität bedeckt,
- die Quantenvorrichtung durch die ersten Befestigungselemente an dem ersten Abschnitt befestigt ist und
- die elektrisch leitfähigen Elemente und/oder Wellenleiter mit der Quantenvorrichtung verbunden sind und sich bis außerhalb des ersten und des zweiten Abschnitts erstrecken.

2. Baugruppe nach Anspruch 1, ferner umfassend einen ausgeschnittenen Abschnitt (121) an der ersten Kavität (14b), wobei die Quantenvorrichtung (16) in dem ausgeschnittenen Abschnitt bereitgestellt ist.

3. Baugruppe nach Anspruch 2, wobei der ausgeschnittene Abschnitt eine erste Tiefe aufweist und die Quantenvorrichtung eine erste Höhe aufweist, wobei die erste Höhe die erste Tiefe überschreitet.

4. Baugruppe nach einem der vorhergehenden Ansprüche, ferner umfassend eine elektromagnetische Schirmung (26), die einen Hauptabschnitt des ersten und des zweiten Abschnitts umgibt.

5. Baugruppe nach einem der vorhergehenden Ansprüche, die auf eine Temperatur unter 100 K gekühlt ist.

6. Verfahren zum Montieren einer Quantenvorrichtung in einer Baugruppe nach einem der vorhergehenden Ansprüche, wobei das Verfahren umfasst:
a) Befestigen der Quantenvorrichtung (16) an dem ersten Abschnitt (12b), um mindestens einen Abschnitt der ersten Kavität (14b) zu bedecken,
b) Befestigen des zweiten Abschnitts an dem ersten Abschnitt, derart, dass die Quantenvorrichtung mindestens einen Abschnitt der zweiten Kavität (14a) bedeckt, und
c) elektrisch Verbinden der Quantenvorrichtung mit den elektrisch leitfähigen Elementen und/oder Wellenleitern.

7. Verfahren nach Anspruch 6, wobei Schritt a) das Vorspannen der Quantenvorrichtung in Richtung des ersten Abschnitts über die Leiterplatte (18) umfasst.

8. Verfahren nach einem der Ansprüche 6 bis 7, wobei der erste Abschnitt einen ausgeschnittenen Abschnitt (121) an der ersten Kavität umfasst, wobei Schritt a) das Bereitstellen der Quantenvorrichtung in dem ausgeschnittenen Abschnitt umfasst.

9. Verfahren nach Anspruch 8, wobei der ausgeschnittene Abschnitt eine erste Tiefe aufweist und die Quantenvorrichtung eine erste Höhe aufweist, wobei die erste Höhe die erste Tiefe überschreitet.

10. Verfahren nach einem der Ansprüche 6 bis 9, ferner umfassend einen Schritt des Bereitstellens einer elektromagnetischen Schirmung (26), die einen Hauptabschnitt des ersten und des zweiten Abschnitts umgibt.

11. Verfahren nach einem der Ansprüche 6 bis 10, ferner umfassend einen Schritt des Kühlens der Baugruppe auf eine Temperatur unter 100 K.

## Patentansprüche (Patentansprüche für folgende(n) Vertragsstaat(en): DE, GB)

1. Baugruppe aus einer Quantenvorrichtung (16) und einem Probenhalter (10), wobei der Probenhalter Folgendes umfasst:
- einen ersten Abschnitt (12b) umfassend eine erste Kavität (14b),
- einen zweiten Abschnitt (12a) umfassend eine zweite Kavität (14a),
- erste Befestigungselemente umfassend eine Leiterplatte (18), die konfiguriert ist, um die Quantenvorrichtung in Richtung des ersten Abschnitts vorzuspannen, wobei die Leiterplatte erste elektrisch leitfähige Elemente (181) umfasst, und
- zweite Befestigungselemente (24), die konfiguriert sind, um den ersten und den zweiten Abschnitt aneinander zu befestigen,
wobei:
- die Quantenvorrichtung mindestens einen Teil der ersten Kavität bedeckt,
- die Quantenvorrichtung mindestens einen Teil der zweiten Kavität bedeckt,
- die Quantenvorrichtung durch die ersten Befestigungselemente an dem ersten Abschnitt befestigt ist und
- die ersten elektrisch leitfähigen Elemente elektrisch mit zweiten elektrisch leitfähigen Elementen (161) der Quantenvorrichtung verbunden sind und sich bis außerhalb des ersten und des zweiten Abschnitts erstrecken
- die ersten elektrisch leitfähigen Elemente den zweiten elektrisch leitfähigen Elementen gegenüberliegen.

2. Baugruppe nach Anspruch 1, ferner umfassend einen ausgeschnittenen Abschnitt (121) an der ersten Kavität (14b), wobei die Quantenvorrichtung in dem ausgeschnittenen Abschnitt bereitgestellt ist.

3. Baugruppe nach Anspruch 2, wobei der ausgeschnittene Abschnitt eine erste Tiefe aufweist und die Quantenvorrichtung eine erste Höhe aufweist, wobei die erste Höhe die erste Tiefe überschreitet.

4. Baugruppe nach einem der vorhergehenden Ansprüche, ferner umfassend eine elektromagnetische Schirmung (26), die einen Hauptabschnitt des ersten und des zweiten Abschnitts umgibt.

5. Baugruppe nach einem der vorhergehenden Ansprüche, die auf eine Temperatur unter 100 K gekühlt ist.

6. Baugruppe nach Anspruch 1, ferner umfassend dritte elektrisch leitfähige Elemente (22') zwischen den ersten und den zweiten elektrisch leitfähigen Elementen.

7. Verfahren zum Montieren einer Quantenvorrichtung in einer Baugruppe nach einem der vorhergehenden Ansprüche, wobei das Verfahren umfasst:
a) Befestigen der Quantenvorrichtung (16) an dem ersten Abschnitt (12b), um mindestens einen Abschnitt der ersten Kavität (14b) zu bedecken,
b) Befestigen des zweiten Abschnitts (12a) an dem ersten Abschnitt, derart, dass die Quantenvorrichtung mindestens einen Abschnitt der zweiten Kavität (14a) bedeckt, und
c) elektrisch Verbinden der Quantenvorrichtung mit den elektrisch leitfähigen Elementen.

8. Verfahren nach Anspruch 7, wobei Schritt a) das Vorspannen der Quantenvorrichtung in Richtung des ersten Abschnitts über die Leiterplatte (18) umfasst.

9. Verfahren nach einem der Ansprüche 7 bis 8, wobei der erste Abschnitt einen ausgeschnittenen Abschnitt (121) an der ersten Kavität umfasst, wobei Schritt a) das Bereitstellen der Quantenvorrichtung in dem ausgeschnittenen Abschnitt umfasst.

10. Verfahren nach Anspruch 9, wobei der ausgeschnittene Abschnitt eine erste Tiefe aufweist und die Quantenvorrichtung eine erste Höhe aufweist, wobei die erste Höhe die erste Tiefe überschreitet.

11. Verfahren nach einem der Ansprüche 7 bis 10, ferner umfassend einen Schritt des Bereitstellens einer elektromagnetischen Schirmung (26), die einen Hauptabschnitt des ersten und des zweiten Abschnitts umgibt.

12. Verfahren nach einem der Ansprüche 7 bis 11, ferner umfassend einen Schritt des Kühlens der Baugruppe auf eine Temperatur unter 100 K.

## Revendications

1. Assemblage d'un dispositif quantique (16) et d'un porte-échantillon (10), le porte-échantillon comprenant :
- une première partie (12b) comprenant une première cavité (14b),
- une seconde partie (12a) comprenant une seconde cavité (14a),
- des premiers éléments de fixation comprenant une carte de circuit imprimé (18) configurée pour polariser le dispositif quantique vers la première partie, la carte de circuit imprimé comprenant des éléments électriquement conducteurs et/ou des guides d'ondes, et
- des seconds éléments de fixation (24) configurés pour fixer les première et seconde parties l'une à l'autre,
dans lequel :
- le dispositif quantique recouvre au moins une partie de la première cavité,
- le dispositif quantique recouvre au moins une partie de la seconde cavité,
- le dispositif quantique est fixé à la première partie par les premiers éléments de fixation, et
- les éléments électriquement conducteurs et/ou les guides d'ondes sont connectés au dispositif quantique et s'étendent à l'extérieur des première et seconde parties.

2. Assemblage selon la revendication 1, comprenant en outre une partie découpées (121) au niveau de la première cavité (14b), le dispositif quantique (16) étant fourni dans la partie découpées.

3. Assemblage selon la revendication 2, dans lequel la partie découpée a une première profondeur et le dispositif quantique a une première hauteur, où la première hauteur est supérieure à la première profondeur.

4. Assemblage selon l'une quelconque des revendications précédentes, comprenant en outre un blindage électromagnétique (26) entourant une partie principale des première et seconde parties.

5. Assemblage selon l'une quelconque des revendications précédentes, refroidi à une température inférieure à 100K.

6. Procédé de montage d'un dispositif quantique dans un assemblage selon l'une quelconque des revendications précédentes, le procédé comprenant :
a) la fixation du dispositif quantique (16) à la première partie (12b) de manière à recouvrir au moins une partie de la première cavité (14b),
b) la fixation de la seconde partie à la première partie de manière à ce que le dispositif quantique recouvre au moins une partie de la seconde cavité (14a), et
c) la connexion de manière électrique du dispositif quantique aux éléments électriquement conducteurs et/ou aux guides d'ondes.

7. Procédé selon la revendication 6, dans lequel l'étape a) comprend la polarisation, par le biais de la carte de circuit imprimé (18), du dispositif quantique vers la première partie.

8. Procédé selon l'une quelconque des revendications 6 à 7, dans lequel la première partie comprend une partie découpée (121) au niveau de la première cavité, dans lequel l'étape a) comprend la fourniture du dispositif quantique dans la partie découpée.

9. Procédé selon la revendication 8, dans lequel la partie découpée a une première profondeur et le dispositif quantique a une première hauteur, où la première hauteur est supérieure à la première profondeur.

10. Procédé selon l'une quelconque des revendications 6 à 9, comprenant en outre une étape de fourniture d'un blindage électromagnétique (26) entourant une partie principale des première et seconde parties.

11. Procédé selon l'une quelconque des revendications 6 à 10, comprenant en outre une étape de refroidissement de l'assemblage à une température inférieure à 100K.

## Revendications (Revendications pour l'(les) Etat(s) contractant(s) suivant(s): DE, GB)

1. Assemblage d'un dispositif quantique (16) et d'un porte-échantillon (10), le porte-échantillon comprenant :
- une première partie (12b) comprenant une première cavité (14b),
- une seconde partie (12a) comprenant une seconde cavité (14a),
- des premiers éléments de fixation comprenant une carte de circuit imprimé (18) configurée pour polariser le dispositif quantique vers la première partie, la carte de circuit imprimé comprenant des éléments électriquement conducteurs (181), et
- des seconds éléments de fixation (24) configurés pour fixer les première et seconde parties l'une à l'autre,
dans lequel :
- le dispositif quantique recouvre au moins une partie de la première cavité,
- le dispositif quantique recouvre au moins une partie de la seconde cavité,
- le dispositif quantique est fixé à la première partie par les premiers éléments de fixation, et
- les premiers éléments électriquement conducteurs sont électriquement connectés à des deuxièmes éléments électriquement conducteurs (161) du dispositif quantique et s'étendent à l'extérieur des première et seconde parties
- les premiers éléments électriquement font face aux deuxièmes éléments électriquement conducteurs.

2. Assemblage selon la revendication 1, comprenant en outre une partie découpées (121) au niveau de la première cavité (14b), le dispositif quantique étant fourni dans la partie découpées.

3. Assemblage selon la revendication 2, dans lequel la partie découpée a une première profondeur et le dispositif quantique a une première hauteur, où la première hauteur est supérieure à la première profondeur.

4. Assemblage selon l'une quelconque des revendications précédentes, comprenant en outre un blindage électromagnétique (26) entourant une partie principale des première et seconde parties.

5. Assemblage selon l'une quelconque des revendications précédentes, refroidi à une température inférieure à 100K.

6. Assemblage selon la revendication 1, comprenant en outre des troisièmes éléments électriquement conducteurs (22') entre les premiers et deuxièmes éléments électriquement conducteurs.

7. Procédé de montage d'un dispositif quantique dans un assemblage selon l'une quelconque des revendications précédentes, le procédé comprenant :
a) la fixation du dispositif quantique (16) à la première partie (12b) de manière à recouvrir au moins une partie de la première cavité (14b),
b) la fixation de la seconde partie (12a) à la première partie de manière à ce que le dispositif quantique recouvre au moins une partie de la seconde cavité (14a), et
c) la connexion de manière électrique du dispositif quantique aux éléments électriquement conducteurs.

8. Procédé selon la revendication 7, dans lequel l'étape a) comprend la polarisation, par le biais de la carte de circuit imprimé (18), du dispositif quantique vers la première partie.

9. Procédé selon l'une quelconque des revendications 7 à 8, dans lequel la première partie comprend une partie découpée (121) au niveau de la première cavité, dans lequel l'étape a) comprend la fourniture du dispositif quantique dans la partie découpée.

10. Procédé selon la revendication 9, dans lequel la partie découpée a une première profondeur et le dispositif quantique a une première hauteur, où la première hauteur est supérieure à la première profondeur.

11. Procédé selon l'une quelconque des revendications 7 à 10, comprenant en outre une étape de fourniture d'un blindage électromagnétique (26) entourant une partie principale des première et seconde parties.

12. Procédé selon l'une quelconque des revendications 7 à 11, comprenant en outre une étape de refroidissement de l'assemblage à une température inférieure à 100K.
